# EUROPÄISCHE PATENTSCHRIFT

(11) **EP 2 087 782 B1**
(45) Veröffentlichungstag und Bekanntmachung des Hinweises auf die Patenterteilung: **15.06.2011**
(21) Anmeldenummer: 06828648.3
(22) Anmeldetag: 06.12.2006
(51) Int. Cl.: H05K 9/00, H01F 27/36

(54) **ANORDNUNG ZUR FELDSTÄRKENREDUZIERUNG AN EINER ELEKTRODE**
ARRANGEMENT FOR REDUCING THE FIELD STRENGTH IN AN ELECTRODE
DISPOSITIF POUR RÉDUIRE L'INTENSITÉ DE CHAMP SUR UNE ÉLECTRODE

(43) Veröffentlichungstag der Anmeldung: 12.08.2009
(73) Patentinhaber: SIEMENS AKTIENGESELLSCHAFT, 80333 München (DE)
(72) Erfinder: HOPPE, Jens, 90592 Schwarzenbruck (DE); JAHNEL, Dietmar, 53842 Troisdorf (DE); MÜLLER, Klaus, 90530 Wendelstein (DE); SCHLAGER, Johann, 90475 Nürnberg (DE)
(86) Internationale Anmeldenummer: PCT/DE2006/002205
(87) Internationale Veröffentlichungsnummer: WO 2008/067783

(56) Entgegenhaltungen:
- WO-A-98/22958
- DE-C- 930 402
- GB-A- 2 025 697

## Beschreibung

Die Erfindung betrifft eine Anordnung zur Reduktion der elektrischen Feldstärke an einer Stirnseite einer Elektrode, wobei die Stirnseite der Elektrode von zumindest einer elektrischen Barriere umgeben und eine Abschirmelektrode mit einem definierten Spannungspotenzial in der Nähe der Stirnelektrode angeordnet ist.

Aus dem Stand der Technik DE 930 402 C ist bereits eine Anordnung dieser Art bekannt.

Zur Abschirmung von hohen elektrischen Feldstärken, werden an schmalen elektrischen Kanten aufgrund der hohen elektrischen Feldstärken so genannte Abschirmdrähte zur Reduzierung der elektrischen Feldstärke verwendet. Diese Abschirmdrähte in zumeist einfacher oder zweifacher Anordnung vermindern die Feldstärke an einer insbesondere schmalen Elektrode. Hierzu ist der Abschirmdraht meist mit einer elektrisch wirksamen, parallel zur Abschirmung verlaufenden Barriere verbunden, die ebenfalls zur Fixierung der exakten Lage des Abschirmdrahtes relativ zur Elektrode dient.

Nachteilig ist hierbei, dass dennoch hohe Feldstärken entstehen können und ein Verbindungselement zwischen der Barriere und dem Abschirmdraht notwendig ist, wobei die Verbindung ein elektrischer Isolator sein muss.

Aufgabe der vorliegenden Erfindung ist es daher eine Möglichkeit bereitzustellen, die Abschirmelektrode einfach und schnell relativ zur Elektrode positionieren zu können. Gelöst wird die Aufgabe durch die Merkmale des Patentanspruchs 1 und des Patentanspruchs 9. Erfindungsgemäß ist vorgesehen, dass ein isolierendes Halteelement an der Elektrode angebracht ist und die Abschirmelektrode durch das Halteelement relativ zur Elektrode positioniert und fixiert ist. Durch die Nutzung eines isolierenden Halteelementes, das unmittelbar mit der Elektrode in mechanischem Kontakt steht, ist eine wesentlich einfachere und schnellere Positionierung der Abschirmelektrode relativ zur Stirnseite der Elektrode möglich. Vorteilhafterweise wird das Halteelement direkt mit der Elektrode mechanisch verbunden.

In einer vorteilhaften Ausgestaltung der Anordnung ist vorgesehen, dass das Halteelement zur Aufnahme von mehreren Abschirmelektroden geeignet ist. Insbesondere durch vorgegebene Aussparungen innerhalb des Halteelementes beziehungsweise durch entsprechende Ausformungen in Form von Mulden an der Außenseite des Halteelementes ist eine einfache Positionierung der Abschirmelektroden relativ zueinander sowie relativ zur Elektrode mittels des Halteelements möglich.

Vorteilhafterweise ist das Halteelement zwischen der Elektrode und der Barriere angeordnet. Des Weiteren ist vorteilhafterweise vorgesehen, dass die Barriere an das Halteelement befestigbar ist. Durch die Maßnahme ist gewährleistet, dass die Barriere und die Abschirmelektroden relativ zur Stirnseite der Elektrode schnell und einfach positionierbar sind. Zur Vermeidung von elektrischen Überschlägen und Kurzschlüsse ist das Halteelement zumindest teilweise aus einem elektrischen Isolationsmaterial, insbesondere einem Pressspan, gefertigt.

Vorteilhafterweise ist vorgesehen, dass die Barriere und/oder die Abschirmelektroden in das Halteelement steckbar sind.

Mittels dieses modularen Aufbaus können die einzelnen Segmente, wie das Halteelement, die Barriere und die Abschirmelektroden, separat hergestellt und mittels eines entsprechenden Steckmechanismussystems ineinander gesteckt und somit relativ zueinander positioniert werden. Alternativ ist vorgesehen, dass die Barriere und die Abschirmelektrode fest mit dem Halteelement verbunden ist, so dass hier die gesamte Einheit bestehend aus Halteelement, Abschirmelektroden und Barrieren in Gänze auf die Stirnseite der Elektrode gesetzt werden kann.

Die Abschirmelektrode weist vorteilhafterweise einen runden oder einen vieleckigen Querschnitt auf, wobei das Halteelement eine entsprechend korrespondierende Aussparung zum Querschnitt der Abschirmelektrode aufweist. Des Weiteren sind zur effektiven Reduzierung der Feldstärken an der Stirnseite der Elektrode die Abschirmelektroden symmetrisch beziehungsweise asymmetrisch relativ zur Stirnseite der Elektrode anordbar.

Gelöst wird die Aufgabe ebenfalls durch ein Halteelement zur Halterung einer Abschirmelektrode relativ zu einer Stirnseite einer Elektrode, wobei erfindungsgemäß vorgesehen ist, dass das Halteelement mit der Elektrode verbindbar ist und somit die Abschirmelektrode relativ zur Stirnseite der Elektrode positionierbar und fixierbar ist.

Vorteilhafterweise ist die Abschirmelektrode in das Halteelement bezüglich vorgebbarer Positionen steckbar. Hierdurch kann schon während des Produktionsprozesses die relative Lage der Abschirmelektroden zueinander beziehungsweise relativ zur Stirnseite der Elektrode festgelegt werden. Des Weiteren besteht das Halteelement vorteilhafterweise aus einem elektrischen Isolationsmaterial.

Weitere vorteilhafte Ausgestaltungen der Erfindung sind in den Unteransprüchen beschrieben. Die Erfindung wird anhand der nachfolgenden Zeichnungen näher erläutert. Es zeigen:
- Fig. 1: den Stand der Technik zu bisherigen Anordnun- gen zur Reduzierung der elektrischen Feldstär- ke an der Stirnseite einer Elektrode;
- Fig. 2: eine erfindungsgemäße Anordnung mit drei asym- metrisch zur Stirnfläche einer Elektrode ange- ordneten Abschirmelektroden.
- Fig. 3: eine erfindungsgemäße Anordnung mit einem mo- dularen Aufbau des Halteelements für drei a- symmetrisch zur Stirnfläche einer Elektrode angeordnete Abschirmelektroden.

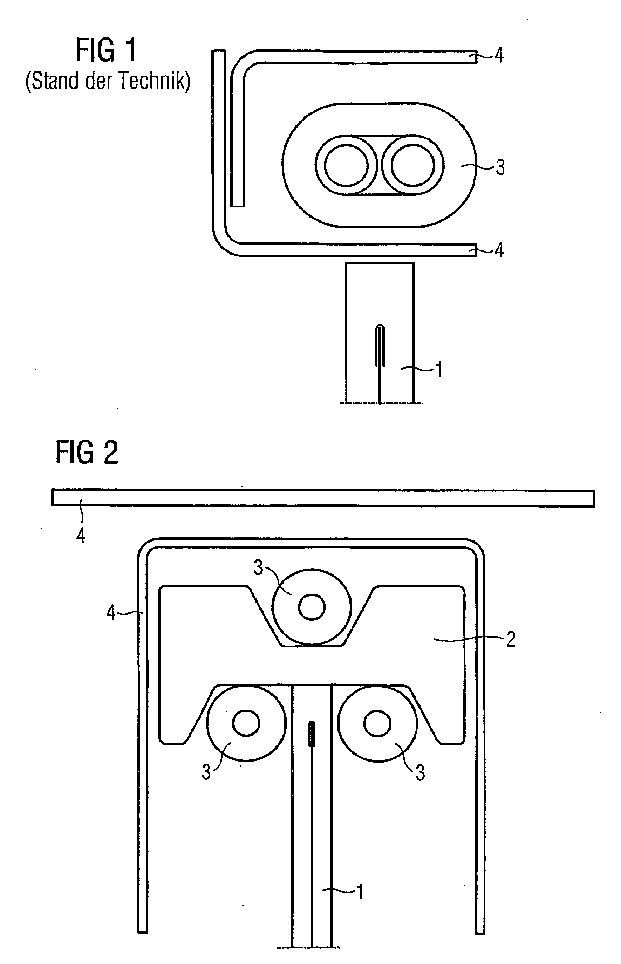

Die Figur Fig. 1 zeigt als Schnittzeichnung den Stand der Technik für eine Anordnung zur Reduzierung der Feldstärke an der Stirnseite einer Elektrode 1 mit einem zweifach ausgeführten Abschirmdraht 3, wobei der Abschirmdraht 3 oberhalb der Stirnseite der Elektrode 1 an der Barriere 4 fixiert ist.

Im Gegensatz dazu zeigt die Figur Fig. 2 als Schnittzeichnung ein erfindungsgemäßes Halteelement 2, wobei relativ zur Stirnseite der Elektrode 1 drei Abschirmelektroden 3 mit dem Halteelement 2 verbunden sind. Des Weiteren dient das Halteelement 2 zur Halterung der Barrieren 4, wobei die Barriere 4 nun nicht mehr nur ausschließlich an der Stirnseite der Elektrode 1 angeordnet sind, sondern auch entlang der Längsseite der Elektrode 1 anordbar sind. Dies ist daher möglich, da das Halteelement 2 an der Stirnseite der Elektrode 1 eine genügende mechanische Stabilität für eine entsprechende Barrierenkonstruktion längs, zumindest des Oberteils, der Elektrode 1 gewährleistet.

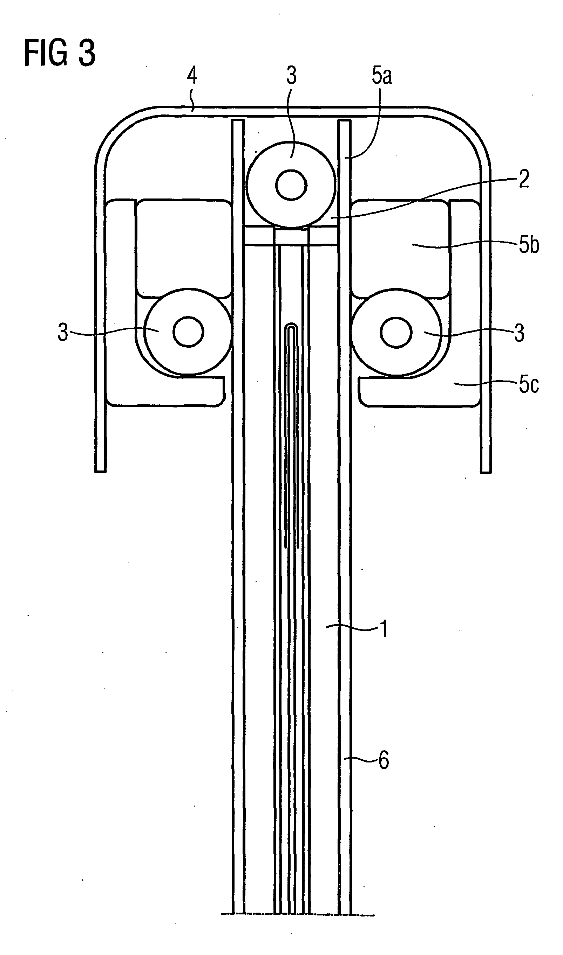

Die Figur FIG.3 zeigt eine erfindungsgemäße Anordnung mit einem modularen Aufbau des Halteelements 2 für drei asymmetrisch zur Stirnfläche einer Elektrode 1 angeordnete Abschirmelektroden 3 als Schnittzeichnung. Das Halteelement 2 gemäß der Figur FIG.3 besteht aus drei Teilelementen 5a bis 5c, die modular miteinander mittels geeigneter Befestigungselemente, wie beispielsweise Schrauben oder Kleber, verbindbar sind. Durch den modularen Aufbau des Halteelements 2 ist nicht nur eine leichtere Verbindung der Abschirmdrähte 3 mit dem Halteelement 2 möglich, sondern die Teilelemente 5a bis 5c können separat hergestellt und erst am Aufstellungsort der Anordnung zusammengesetzt werden.

Das Halteelement 2 besteht gemäß dem Ausführungsbeispiel der Figur FIG.3 aus zwei als Isolationskörper ausgebildeten Teilelementen 5b und 5c und einem rohrförmigen Teilelement 5a als Teil einer Außenwand 6 um die Elektrode 1. Die Teilelemente 5b und 5c sind entweder mittels geeigneter Befestigungselementen, beispielsweise mittels Schrauben, verbindbar oder sind durch geeignete Oberflächenausformungen, beispielsweise einer Nut-Feder-Verbindung, miteinander steck- und damit verbindbar. Gleiches gilt für das in der Schnittzeichnung FIG.3 gezeigt weitere rohrförmige Teilelement 5a, das mit geeigneten Befestigungselementen mit den übrigen Teilelementen 5b und 5c verbindbar ist und damit das Halteelement 2 bildet.

## Patentansprüche

1. Anordnung zur Reduktion der elektrischen Feldstärke an einer Stirnseite einer Elektrode (1), wobei die Stirnseite der Elektrode (1) von zumindest einer elektrischen Barriere (4) umgeben und eine Abschirmelektrode (3) mit einem definierten elektrischen Spannungspotenzial in der Nähe der Stirnseite der Elektrode (1) angeordnet ist, mit einem Halteelement (2), das an der Elektrode (1) angebracht ist und die Abschirmelektrode (3) relativ zur Elektrode (1) positioniert und fixiert,
**dadurch gekennzeichnet, dass** das Halteelement (2) ein elektrisch isolierendes Material, insbesondere ein Pressspan, umfasst.

2. Anordnung nach Anspruch 1,
**dadurch gekennzeichnet, dass** das Halteelement (2) zur Aufnahme von zumindest zwei Abschirmelektroden (3) geeignet ist.

3. Anordnung nach einem der Ansprüche 1 oder 2,
**dadurch gekennzeichnet, dass** das Halteelement (2) zwischen der Elektrode (1) und der Barriere (4) angeordnet ist.

4. Anordnung nach einem der Ansprüche 1 bis 3,
**dadurch gekennzeichnet, dass** die Barriere (4) an das Halteelement (2) befestigbar ist.

5. Anordnung nach einem der Ansprüche 1 bis 4,
**dadurch gekennzeichnet, dass** die Abschirmelektrode (3) mit der Elektrode (1) elektrisch verbunden ist.

6. Anordnung nach einem der Ansprüche 1 bis 5,
**dadurch gekennzeichnet, dass** die Barriere (4) und/oder die Abschirmelektrode (3) in das Halteelement (2) steckbar sind.

7. Anordnung nach einem der Ansprüche 1 bis 5,
**dadurch gekennzeichnet, dass** die Barriere (4) und/oder die Abschirmelektrode (3) fest mit dem Halteelement (2) verbunden sind.

8. Anordnung nach einem der Ansprüche 1 bis 7,
**dadurch gekennzeichnet, dass** die Abschirmelektrode (3) einen runden oder einen vieleckigen Querschnitt aufweist.

9. Anordnung nach einem der Ansprüche 1 bis 8,
**dadurch gekennzeichnet, dass** zumindest zwei Abschirmelektroden (3) symmetrisch oder asymmetrisch relativ zur Stirnseite der Elektrode (1) angeordnet sind.

10. Halteelement (2) zur Halterung einer Abschirmelektrode (3) relativ zu einer Stirnseite einer Elektrode (1),
**dadurch gekennzeichnet, dass** das Halteelement (2) mit der Elektrode verbindbar ist und somit die Abschirmelektrode (3) relativ zur Stirnseite der Elektrode (1) positionierbar und fixierbar ist.

11. Halteelement (2) nach Anspruch 10,
**dadurch gekennzeichnet, dass** die Abschirmelektrode (3) in das Halteelement (2) bezüglich vorgebbarer Positionen steckbar ist.

12. Halteelement (2) nach einem der Ansprüche 10 oder 11,
**dadurch gekennzeichnet, dass** das Halteelement (2) ein elektrisches Isolationsmaterial umfasst.

13. Halteelement (2) nach einem der Ansprüche 10 bis 12,
**dadurch gekennzeichnet, dass** das Halteelement (2) aus Teilelementen (5a, 5b, 5c) zusammensetzbar ist, wobei die Teilelemente (5a, 5b, 5c) mittels geeigneter Befestigungselemente miteinander verbindbar sind.

## Claims

1. Arrangement for reducing the electric field strength on an end face of an electrode (1), wherein the end face of the electrode (1) is surrounded by at least one electrical barrier (4) and a shielding electrode (3) having a defined electrical voltage potential is arranged in the vicinity of the end face of the electrode (1), with a holding element (2) which is fitted to the electrode (1) and positions and fixes the shielding electrode (3) relative to the electrode (1), **characterized in that** the holding element (2) comprises an electrical insulation material, in particular a pressboard.

2. Arrangement according to Claim 1,
**characterized in that**
the holding element (2) is suitable for receiving at least two shielding electrodes (3).

3. Arrangement according to either of Claims 1 and 2,
**characterized in that**
the holding element (2) is arranged between the electrode (1) and the barrier (4).

4. Arrangement according to any of Claims 1 to 3,
**characterized in that**
the barrier (4) can be fixed to the holding element (2).

5. Arrangement according to any of Claims 1 to 4,
**characterized in that**
the shielding electrode (3) is electrically connected to the electrode (1).

6. Arrangement according to any of Claims 1 to 5,
**characterized in that**
the barrier (4) and/or the shielding electrode (3) can be inserted into the holding element (2).

7. Arrangement according to any of Claims 1 to 5,
**characterized in that**
the barrier (4) and/or the shielding electrode (3) are fixedly connected to the holding element (2).

8. Arrangement according to any of Claims 1 to 7,
**characterized in that**
the shielding electrode (3) has a round or a polygonal cross section.

9. Arrangement according to any of Claims 1 to 8,
**characterized in that**
at least two shielding electrodes (3) are arranged symmetrically or asymmetrically relative to the end face of the electrode (1).

10. Holding element (2) for retaining a shielding electrode (3) relative to an end face of an electrode (1),
**characterized in that**
the holding element (2) can be connected to the electrode and the shielding electrode (3) can thus be positioned and fixed relative to the end face of the electrode (1).

11. Holding element (2) according to Claim 10,
**characterized in that**
the shielding electrode (3) can be inserted into the holding element (2) with respect to predeterminable positions.

12. Holding element (2) according to either of Claims 10 and 11,
**characterized in that**
the holding element (2) comprises an electrical insulation material.

13. Holding element (2) according to any of Claims 10 to 12,
**characterized in that**
the holding element (2) can be composed from partial elements (5a, 5b, 5c), wherein the partial elements (5a, 5b, 5c) can be connected to one another by means of suitable fixing elements.

## Revendications

1. Dispositif pour réduire l'intensité d'un champ électrique sur un côté frontal d'une électrode ( 1 ), dans lequel le côté frontal de l'électrode ( 1 ) est entouré d'au moins une barrière ( 4 ) électrique et une électrode ( 3 ) de protection, ayant un potentiel de tension électrique définie, est disposée à proximité du côté frontal de l'électrode ( 1 ), comprenant un élément ( 2 ) de maintien qui est mis sur l'électrode ( 1 ) et qui met l'électrode ( 3 ) de protection en position par rapport à l'électrode ( 1 ) et l'immobilise,
**caractérisé en ce que**
l'élément ( 2 ) de maintien comprend un matériau isolant du point de vue électrique, notamment un carton comprimé.

2. Dispositif suivant la revendication 1,
**caractérisé en ce que**
l'élément ( 1 ) de maintien est approprié à la réception d'au moins deux électrodes ( 3 ) de protection.

3. Dispositif suivant l'une des revendications 1 ou 2,
**caractérisé en ce que**
l'élément (2) de maintien est disposé entre l'électrode ( 1 ) et la barrière ( 4 ).

4. Dispositif suivant l'une des revendications 1 à 3,
**caractérisé en ce que**
la barrière ( 4 ) peut être fixée à l'élément ( 2 ) de maintien.

5. Dispositif suivant l'une des revendications 1 à 4,
**caractérisé en ce que**
l'électrode ( 3 ) de protection est reliée électriquement à l'électrode ( 1 ).

6. Dispositif suivant l'une des revendications 1 à 5,
**caractérisé en ce que**
la barrière ( 4 ) et/ou l'électrode ( 3 ) de protection peuvent être enfoncées dans l'élément ( 2 ) de maintien.

7. Dispositif suivant l'une des revendications 1 à 5,
**caractérisé en ce que**
la barrière ( 4 ) et/ou l'électrode ( 3 ) de protection sont reliées rigidement à l'élément ( 2 ) de maintien.

8. Dispositif suivant l'une des revendications 1 à 7,
**caractérisé en ce que**
l'électrode ( 3 ) de protection a une section transversale circulaire ou polygonale.

9. Dispositif suivant l'une des revendications 1 à 8,
**caractérisé en ce qu'**au moins deux électrodes ( 3 ) de protection sont disposées d'une manière symétrique ou dissymétrique par rapport au côté frontal de l'électrode ( 1 ).

10. Elément ( 2 ) de maintien pour le maintien d'une électrode ( 3 ) de protection par rapport à un côté frontal d'une électrode ( 1 ), **caractérisé en ce que** l'élément ( 2 ) de maintien peut être relié à l'électrode et ainsi l'électrode ( 3 ) de protection peut être mise en position par rapport au côté frontal de l'électrode ( 1 ) et être immobilisée.

11. Elément ( 2 ) de maintien suivant la revendication 10,
**caractérisé en ce que**
l'électrode ( 3 ) de protection peut être enfoncée dans l'élément ( 2 ) de maintien dans des positions qui peuvent être prescrites.

12. Elément ( 2 ) de maintien suivant l'une des revendications 10 ou 11,
**caractérisé en ce que**
l'élément ( 2 ) de maintien comprend un matériau isolant du point de vue électrique.

13. Elément ( 2 ) de maintien suivant l'une des revendications 10 à 12,
**caractérisé en ce que**
l'élément ( 2 ) de maintien peut se composer de sous-éléments ( 5a, 5b, 5c ), les sous-éléments ( 5a, 5b, 5c ) pouvant être reliés les uns aux autres, au moyen d'éléments de fixation appropriés.
